# EUROPEAN PATENT APPLICATION

(11) **EP 4 685 561 A1**
(43) Date of publication of application: **28.01.2026**
(21) Application number: 23954770.6
(22) Date of filing: 05.10.2023
(51) Int. Cl.: G03F 7/004, G03F 7/09, G03F 7/11

(54) **PHOTOSENSITIVE ELEMENT, METHOD FOR FORMING RESIST PATTERN, AND METHOD FOR MANUFACTURING PRINTED WIRING BOARD**

(71) Applicant: Resonac Corporation, Tokyo 105-7325 (JP)
(72) Inventor: TODA, Natsuki, Tokyo 105-7325 (JP); TOGASAKI, Kei, Tokyo 105-7325 (JP); IWASHITA, Kenichi, Tokyo 105-7325 (JP); YOSHIHARA, Kensuke, Tokyo 105-7325 (JP); KAGUCHI, Yosuke, Tokyo 105-7325 (JP); WATANABE, Yusaku, Tokyo 105-7325 (JP)
(74) Representative: Hoffmann Eitle
(86) International application number: PCT/JP2023/036334
(87) International publication number: WO 2025/074559

(57) **Abstract**

A photosensitive element including: a support film, an optical adjustment layer, and a photosensitive layer in this order, in which the optical adjustment layer has an absorbance of 0.060 or less for light with a wavelength of 365 nm, and the optical adjustment layer has a refractive index of 1.800 or less for light with a wavelength of 365 nm.

## Description

### Technical Field

The present disclosure relates to a photosensitive element, a method for forming a resist pattern, and a method for producing a printed wiring board.

### Background Art

Conventionally, in the field of printed wiring board production, photosensitive resin compositions and photosensitive elements including a layer formed on a support film using a photosensitive resin composition (hereinafter, also referred to as "photosensitive layer") have been widely used as resist materials used for an etching treatment or a plating treatment (see, for example, the following Patent Literature 1).

A printed wiring board is produced by, for example, the following procedure using the above-described photosensitive element. That is, first, a photosensitive layer of a photosensitive element is laminated on a circuit-forming substrate such as a copper-clad laminated plate. In this case, the photosensitive layer is laminated such that a surface of the photosensitive layer on the opposite side of the surface that is in contact with the support film comes to close contact with the surface of the circuit-forming substrate where a circuit is formed. Lamination is carried out by, for example, heating and pressing the photosensitive layer on the circuit-forming substrate (normal pressure lamination method).

Next, a desired region of the photosensitive layer is exposed to light through the support film using a mask film or the like, to thereby generate radicals. The generated radicals pass through several reaction pathways and contribute to a cross-linking reaction of a photopolymerizable compound (photocuring reaction). Next, the support film is peeled, subsequently uncured parts of the photosensitive layer are removed by dissolving or dispersing in a developing solution, and a resist pattern is formed. Next, the resist pattern is used as a resist and is subjected to an etching treatment or a plating treatment to form a conductor pattern, and finally, the photocured parts of the photosensitive layer (resist pattern) are released (removed).

### Citation List

### Patent Literature

Patent Literature 1: Japanese Unexamined Patent Publication No. 2013-195712

### Summary of Invention

### Technical Problem

Along with the trend to increase the density of printed wiring boards in recent years, it is required to form finer resist patterns with a line width/space width ratio of 2/2 (unit: µm) or less on package substrates. Conventional photosensitive resin compositions and photosensitive elements have room for further improvement in terms of resolution. Furthermore, in a step of forming a resist pattern, the photosensitive layer may be exposed to light and then developed after a certain period of time has elapsed. This is also referred to as post-exposure delay. However, the resolution may deteriorate due to the post-exposure delay.

The present disclosure was achieved in consideration of the problems associated with the above-described conventional technologies, and it is an object of the present disclosure to provide a photosensitive element that can improve resolution and also suppress the deterioration of resolution caused by post-exposure delay, a method for forming a resist pattern, and a method for producing a printed wiring board.

### Solution to Problem

The present disclosure provides the following photosensitive element, method for forming a resist pattern, and method for producing a printed wiring board.
[1] A photosensitive element including: a support film, an optical adjustment layer, and a photosensitive layer in this order,
   wherein the optical adjustment layer has an absorbance of 0.060 or less for light with a wavelength of 365 nm, and the optical adjustment layer has a refractive index of 1.800 or less for light with a wavelength of 365 nm.
[2] The photosensitive element according to the above-described item [1], wherein the optical adjustment layer contains a water-soluble resin.
[3] The photosensitive element according to the above-described item [1] or [2], wherein the optical adjustment layer has a thickness of 1 to 15 µm.
[4] The photosensitive element according to any one of the above-described items [1] to [3], wherein the photosensitive layer has a thickness of 1 to 14 µm.
[5] A method for forming a resist pattern, the method including:
   a step of using the photosensitive element according to any one of the above-described items [1] to [4] to arrange, on a substrate, a photosensitive layer, an optical adjustment layer, and a support film in this order from the substrate side;
   a step of removing the support film and exposing the photosensitive layer to actinic rays through the optical adjustment layer; and
   a step of removing uncured parts of the photosensitive layer and the optical adjustment layer from the substrate.
[6] The method for forming a resist pattern according to the above-described item [5], wherein light exposure is performed using an exposure machine having a lens numerical aperture of 0.16 or greater.
[7] A method for producing a printed wiring board, the method including:
   a step of subjecting a substrate on which a resist pattern has been formed by the method for forming a resist pattern according to the above-described item [5] or [6], to an etching treatment or a plating treatment to form a conductor pattern.

### Advantageous Effects of Invention

According to the present disclosure, a photosensitive element that can improve resolution and suppress the deterioration of resolution caused by post-exposure delay, a method for forming a resist pattern, and a method for producing a printed wiring board can be provided.

### Brief Description of Drawings

[Fig. 1] Fig.1 is a schematic cross-sectional view illustrating an embodiment of a photosensitive element of the present disclosure.
[Fig. 2] Fig.2 is a diagram schematically illustrating an example of a step of producing a printed wiring board by a semi-additive method.

### Description of Embodiments

Suitable embodiments of the present disclosure will be described in detail below with reference to the drawings as necessary. In the following embodiments, it is needless to say that constituent elements (also including elemental steps and the like) of the embodiments are not necessarily essential, unless particularly stated otherwise or considered to be clearly essential in principle. The same also applies to numerical values and ranges, and this should not be construed as unduly limiting the present disclosure.

The term "(meth)acrylic acid" in the present specification means at least one of acrylic acid and its corresponding methacrylic acid. The same also applies to other similar expressions such as (meth)acrylate.

The term "step" in the present specification refers not only to an independent step, but a step that cannot be clearly distinguished from other steps is also included in the present term as long as the intended action of the step is achieved. The term "layer" in the present specification includes a structure having a shape formed over the entire surface as well as a structure having a shape formed on a portion, when viewed in a plan view. In the present specification, the term "solid content" refers to the non-volatile content in the resin composition, excluding volatile substances such as water and organic solvents. That is, the term "solid content" refers to components other than solvents such as water and organic solvents, which do not evaporate during a drying step, and also includes components that are liquid, syrup-like, or wax-like at room temperature (25°C; hereinafter, the same).

A numerical value range indicated using the term "to" in the present specification indicates a range including the numerical values described before and after the term "to" as the minimum value and the maximum value, respectively. With regard to a numerical value range described in stages in the present specification, the upper limit value or lower limit value of a numerical value range of a certain stage may be replaced with the upper limit value or lower limit value of a numerical value range of another stage. Regarding a numerical value range described in the present specification, the upper limit value or lower limit value of the numerical value range may be replaced with a value shown in the Examples.

Unless particularly stated otherwise, the materials listed as examples below may be used singly, or two or more kinds thereof may be used in combination. The content of each component in the composition means, in a case where there are a plurality of substances corresponding to each component in the composition, the total amount of the plurality of substances existing in the present composition, unless particularly stated otherwise.

### [Photosensitive element]

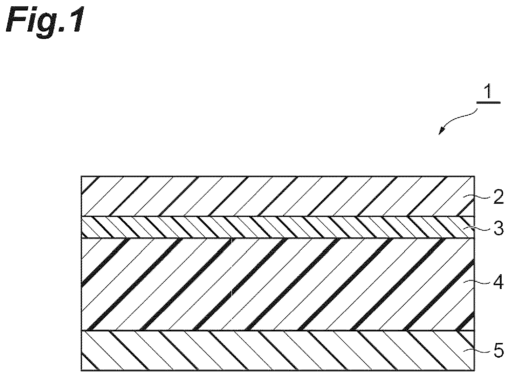

A photosensitive element 1 according to the present embodiment includes, as shown in Fig. 1, a support film 2, an optical adjustment layer 3, and a photosensitive layer 4 in this order, and may further include layers other than those, such as a protective layer 5. Hereinafter, each layer in the photosensitive element according to the present embodiment will be described in detail.

### <Support film>

Any support film can be used without particular limitation. Examples thereof include polyester films such as polyethylene terephthalate (PET), polybutylene terephthalate (PBT), and polyethylene-2,6-naphthalate (PEN); and polyolefin films such as polypropylene and polyethylene. Among them, a polyester film may be used. When a polyester film is used as the support film, there is a tendency that the mechanical strength and resistance to heat of the support film can be improved. Furthermore, by using a polyester film, there is a tendency that defects such as wrinkles in the optical adjustment layer occurring when forming the optical adjustment layer on the support film can be suppressed, and that workability can be improved. From the viewpoint that the occurrence of minute voids in the resist pattern can be suppressed, a polyester film containing particles (a lubricating agent or the like) may also be used. When a polyester film containing particles (a lubricating agent or the like) is used, the optical adjustment layer may be formed on the surface on the side having particles (lubricating agent or the like). As such a polyester film, for example, a polyester film having particles (a lubricating agent or the like) kneaded thereinto, a polyester film in which a layer containing particles (a lubricating agent or the like) is formed on both surfaces, or a polyester film in which a layer containing particles (a lubricating agent or the like) is formed on one surface, may be used. The support film may be a single layer or a multilayer.

Examples of a method of adding particles of a lubricating agent or the like into the support film, include a method of kneading particles (a lubricating agent or the like) into the support film, and a method of forming a layer containing particles (a lubricating agent or the like) on the support film by using a known method such as roll coating, flow coating, spray coating, curtain flow coating, dip coating, or slit die coating.

The haze of the support film may be 0.01% to 5.0%, 0.01% to 1.5%, 0.01% to 1.0%, or 0.01% to 0.5%. When this haze is 0.01% or more, the support film itself tends to be more easily produced, and when the haze is 5.0% or less, there is a tendency that when the photosensitive layer of the photosensitive element is formed, detection of foreign materials in the photosensitive layer is more easily achieved. Here, the term "haze" means the degree of cloudiness. The haze in the present disclosure refers to a value measured using a commercially available haze meter (turbidimeter) according to the method specified in JIS K 7105. The haze can be measured with, for example, a commercially available turbidimeter such as NDH-5000 (manufactured by Nippon Denshoku Industries Co., Ltd., product name).

The support film may be obtained by purchasing any film that can be used as a support film of a photosensitive element from among commercially available general industrial films and appropriately processing the film before use. Specific examples thereof include PET films such as "FB-40" (manufactured by Toray Industries, Inc., product name), "A4100", "A1517" (manufactured by Toyobo Co., Ltd., product name), and "G2H" (manufactured by DuPont Teijin Films, Ltd., product name).

The thickness of the support film may be 1 to 200 µm, 1 to 100 µm, 1 to 60 µm, 5 to 60 µm, 10 to 60 µm, 10 to 50 µm, 10 to 40 µm, 10 to 30 µm, or 10 to 25 µm. When the thickness of the support film is 1 µm or more, there is a tendency that breakage of the support film at the time of peeling the support film can be suppressed. Furthermore, when the thickness of the support film is 200 µm or less, economic benefits tend to be easily obtained.

### <Optical adjustment layer>

The photosensitive element according to the present embodiment includes an optical adjustment layer between a support film and a photosensitive layer. The optical adjustment layer has an absorbance of 0.060 or less for light with a wavelength of 365 nm and has a refractive index of 1.800 or less for light with a wavelength of 365 nm.

As the photosensitive element according to the present embodiment includes an optical adjustment layer having a specific absorbance and a specific refractive index such as described above, when the support film is peeled, and the photosensitive layer is exposed to light through the optical adjustment layer, resolution can be improved by suppressing scattering of the light reaching the photosensitive layer, and since the progress of polymerization of an unexposed part can be suppressed by improving the contrast between an exposed part and an unexposed part, the deterioration of resolution caused by post-exposure delay can be suppressed.

From the viewpoint of further improving the resolution and from the viewpoint of further suppressing the deterioration of resolution caused by post-exposure delay, the absorbance of the optical adjustment layer for light with a wavelength of 365 nm may be 0.050 or less, 0.040 or less, 0.030 or less, 0.025 or less, or 0.020 or less. The lower limit value of the absorbance of the optical adjustment layer for light with a wavelength of 365 nm is not particularly limited but may be 0.001 or more. The absorbance of the optical adjustment layer can be adjusted by a conventionally known method (for example, by increasing or decreasing the film thickness). The absorbance can be measured by the method described in the Examples.

From the viewpoint of further improving the resolution and from the viewpoint of further suppressing the deterioration of resolution caused by post-exposure delay, the refractive index of the optical adjustment layer for light with a wavelength of 365 nm may be 1.750 or less, 1.700 or less, 1.650 or less, 1.600 or less, or 1.550 or less. The lower limit value of the refractive index of the optical adjustment layer for light with a wavelength of 365 nm is not particularly limited but may be 1.300 or more. The refractive index of the optical adjustment layer can be adjusted by a conventionally known method (for example, by changing the component ratio of the resin composition for forming an optical adjustment layer). The refractive index can be measured by the method described in the Examples.

The optical adjustment layer may be a layer formed using a resin composition for forming an optical adjustment layer. The resin composition for forming an optical adjustment layer may contain a water-soluble resin. The optical adjustment layer may have water-soluble properties or may have solubility in a developing solution. From the viewpoint that when the support film is peeled from the photosensitive element, unintended peeling between the optical adjustment layer and the photosensitive layer can be suppressed, the adhesive force between the support film and the optical adjustment layer may be smaller than the adhesive force between the optical adjustment layer and the photosensitive layer.

### (Water-soluble resin)

The optical adjustment layer may contain a water-soluble resin. Here, the term "water-soluble resin" means a resin having a solubility in 100 mL of hexane at 25°C of 5 g/100 mL-C₆H₁₄ or less. This solubility can be calculated by mixing hexane at 25°C with a dried water-soluble resin and examining whether the mixture becomes cloudy. Specifically, sample 1 obtained by placing a mixed liquid of A (g) of a dried water-soluble resin and 100 mL of hexane in a colorless transparent glass container equipped with a ground glass stopper, and sample 2 obtained by placing 100 mL of hexane only in the above-described glass container, are each prepared. Next, the samples in the glass containers are mixed by sufficiently shaking, and then it is checked whether froth has disappeared. Immediately after the checking, both containers are placed side by side under diffuse daylight or equivalent light, and a comparison is made between the state of the liquid of sample 1 and the state of the liquid of sample 2. The sample 1 and the sample 2 are compared, and the amount of addition A (g) when the sample 1 begins to be observed to become cloudier or when floating of solids begins to be observed, is defined as the solubility of the water-soluble resin in 100 mL of hexane at 25°C.

Examples of the water-soluble resin include polyvinyl alcohol, polyvinylpyrrolidone, and a water-soluble polyimide. The polyvinyl alcohol can be obtained by saponifying a polyvinyl acetate obtained by polymerizing vinyl acetate. The degree of saponification of the polyvinyl alcohol used in the present embodiment may be 50 mol% or more, 70 mol% or more, or 80 mol% or more. The upper limit of the degree of saponification is 100 mol%. The "degree of saponification" in the present specification refers to a value measured in accordance with JIS K 6726 (1994) (Testing methods for polyvinyl alcohol) specified by the Japanese Industrial Standards.

Regarding the polyvinyl alcohol, two or more kinds thereof having different degrees of saponification, viscosities, degrees of polymerization, modified species, and the like may be used in combination. The average degree of polymerization of the polyvinyl alcohol may be 300 to 5000, 300 to 3500, or 300 to 2000.

The water-soluble resin can be used singly or in combination of two or more kinds thereof. The water-soluble resin may include, for example, polyvinyl alcohol and polyvinylpyrrolidone. In this case, the mass ratio (PVA: PVP) between polyvinyl alcohol and polyvinylpyrrolidone may be 40:60 to 90:10, 50:50 to 90: 10, or 60:40 to 90:10.

The content of the water-soluble resin in the resin composition for forming an optical adjustment layer may be 50 to 700 parts by mass, 60 to 650 parts by mass, or 70 to 600 parts by mass, with respect to 500 parts by mass of water.

The content of the water-soluble resin in the optical adjustment layer may be 99.0% to 99.95% by mass, 99.3% to 99.9% by mass, or 99.5% to 99.8% by mass, based on the total amount of solid content of the optical adjustment layer.

### (Leveling agent)

The resin composition for forming an optical adjustment layer may contain a leveling agent. The leveling agent orients itself on the coating film surface and makes the tension of the coating film surface uniform. Examples of the type of the leveling agent include an acrylic polymer, a vinyl-based agent, a silicone-based agent, and a fluorine-based agent.

From the viewpoint of the solubility in a developing solution, the leveling agent may contain an acrylic polymer. From the viewpoint of setting the adhesiveness between the optical adjustment layer and the support film to be in an appropriate range, and suppressing unintended peeling between each layer while making the adhesive force between the support film and the optical adjustment layer smaller than the adhesive force between the optical adjustment layer and the photosensitive layer, and from the viewpoint of easily suppressing the occurrence of defects (cissing) on the optical adjustment layer surface when forming the optical adjustment layer on the support film, it is preferable that the acrylic polymer includes a copolymer having a structural unit derived from at least one kind selected from the group consisting of butyl (meth)acrylate, isobutyl (meth)acrylate, and a terminal methoxy group EO-modified (meth)acrylate, it is more preferable that the acrylic polymer includes a copolymer having structural units derived from butyl (meth)acrylate and isobutyl (meth)acrylate, and it is even more preferable that the acrylic polymer includes a copolymer having structural units derived from butyl (meth)acrylate, isobutyl (meth)acrylate, and a terminal methoxy group EO-modified (meth)acrylate.

The content of each structural unit constituting the acrylic polymer may be, for example, in the following range based on the total amount of the structural units. From the viewpoint of further reducing the number of defects on the optical adjustment layer surface, and from the viewpoint of further suppressing damage to the optical adjustment layer when the support film is peeled, the content of a structural unit derived from butyl (meth)acrylate may be 2% to 20% by mass, 5% to 15% by mass, or 5% to 10% by mass. From the viewpoint of further reducing the number of defects on the optical adjustment layer surface, and from the viewpoint of further suppressing damage to the optical adjustment layer when the support film is peeled, the content of a structural unit derived from isobutyl (meth)acrylate may be 40% to 80% by mass, 50% to 70% by mass, or 55% to 65% by mass. From the viewpoint of further suppressing the number of defects on the optical adjustment layer surface, and from the viewpoint of further suppressing damage to the optical adjustment layer when the support film is peeled, the content of a structural unit derived from a terminal methoxy group EO-modified (meth)acrylate may be 15% to 45% by mass, 20% to 40% by mass, or 25% to 35% by mass. From the viewpoint of further reducing the number of defects on the optical adjustment layer surface, and from the viewpoint of further suppressing damage to the optical adjustment layer when the support film is peeled, the weight average molecular weight of the acrylic polymer may be 10000 to 40000, or may be 10000 to 20000.

From the viewpoint of further reducing the number of defects on the optical adjustment layer surface and further suppressing damage to the optical adjustment layer when the support film is peeled, the content of the leveling agent in the optical adjustment layer may be 0.01% to 1.0% by mass, 0.05% by to 0.7% by mass, or 0.10% to 0.5% by mass, based on the total amount of solid content of the optical adjustment layer.

### (Other components)

The resin composition for forming an optical adjustment layer may contain an alcohol having 3 or more carbon atoms. The alcohol having 3 or more carbon atoms may be a monohydric alcohol or may be a polyhydric alcohol. The alcohol having 3 or more carbon atoms may contain at least one kind selected from the group consisting of compounds represented by the following Formulas (1) to (4). By containing these alcohols having 3 or more carbon atoms, there is a tendency that the peelability between the optical adjustment layer and the support film can be improved. Therefore, when the support film is peeled from the photosensitive element, there is a tendency that unintended peeling between the optical adjustment layer and the photosensitive layer can be suppressed, and that deterioration of the resolution due to such unintended peeling can be suppressed.

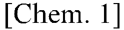

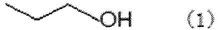

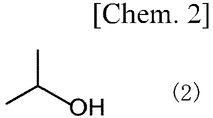

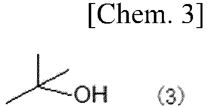

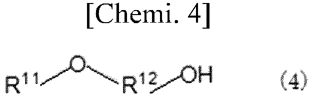

In Formula (4), R¹¹ represents an alkyl group, and R¹² represents an alkylene group. The sum of the numbers of carbon atoms of the group for R¹¹ and the group for R¹² is 3 or greater. From the viewpoint of affinity with water, the sum of the number of carbon atoms of the group for R¹¹ and the group for R¹² may be 10 or less, 8 or less, 7 or less, or 5 or less. The alkyl group represented by R¹¹ may be an alkyl group having 1 to 4 carbon atoms, and the alkylene group represented by R¹² may be an alkylene group having 1 to 3 carbon atoms. The alcohol having 3 or more carbon atoms represented by Formula (4) may be 2-butoxyethanol or 1-methoxy-2-propanol.

The alcohol having 3 or more carbon atoms may be used singly or in combination of two or more kinds thereof. From the viewpoint of suppressing layer separation of the optical adjustment layer, the solubility of the alcohol having 3 or more carbon atoms in water at 20°C may be 300 mL/100 mL-H₂O or more, 500 mL/100 mL-H₂O or more, or 1000 mL/100 mL-H₂O or more.

The "solubility of the alcohol having 3 or more carbon atoms in water at 20°C" in the present specification can be calculated by mixing the alcohol with water at 20°C and examining whether the mixture becomes cloudy. Specifically, sample 3 obtained by placing a mixed liquid of A mL of the alcohol and 100 mL of water in a colorless transparent glass container equipped with a ground glass stopper, and sample 4 obtained by placing only water (100 mL) in such a glass container, are each prepared. Next, the sample 3 and the sample 4 in the glass containers are mixed by sufficiently shaking, and then it is checked whether froth has disappeared. Immediately after the checking, both containers are placed side by side under diffuse daylight or equivalent light, and a comparison is made between the state of the liquid of sample 3 and the state of the liquid of sample 4. The sample 3 and the sample 4 are compared, and the amount of addition A (mL) of the alcohol when the sample 3 is observed to be cloudier, is defined as the solubility of the alcohol in water at 20°C.

The content of the alcohol having 3 or more carbon atoms in the resin composition for forming an optical adjustment layer may be 100 to 2000 parts by mass, or 125 to 1600 parts by mass, with respect to 500 parts by mass of water. When this content is 100 parts by mass or more, the peelability between the optical adjustment layer to be formed and the support film tends to be improved, and when the content is 2000 parts by mass or less, there is a tendency that the solubility of the water-soluble resin is improved, and that the optical adjustment layer is more easily formed.

The content of the alcohol having 3 or more carbon atoms in the optical adjustment layer may be more than 0% by mass to 2.0% by mass or less, 0.001% to 2.0% by mass, or 0.005% to 1.0% by mass, based on the total amount of the optical adjustment layer (total amount of solid content of the resin composition for forming an optical adjustment layer that forms the optical adjustment layer). When this content is 2.0% by mass or less, there is a tendency that diffusion of the alcohol in the subsequent steps can be suppressed, and when the content is 0.001% by mass or more, the peelability between the optical adjustment layer and the support film tends to be improved.

The resin composition for forming an optical adjustment layer may contain an alcohol having fewer than 3 carbon atoms. When the resin composition contains an alcohol having fewer than 3 carbon atoms, the content thereof may be 50 to 375 parts by mass, or 60 to 325 parts by mass, with respect to 500 parts by mass of water. When this content is 50 parts by mass or more, there is a tendency that the solubility of the water-soluble resin is improved, and that the optical adjustment layer is more easily formed, and when the content is 375 parts by mass or less, the peelability between the optical adjustment layer to be formed and the support film tends to be improved. From the viewpoint that the peelability between the optical adjustment layer and the support film is improved, the content of the alcohol having fewer than 3 carbon atoms in the optical adjustment layer may be 0.1% to 10% by mass based on the total amount of the alcohol having 3 or more carbon atoms in the optical adjustment layer (that is, the amount of the alcohol having fewer than 3 carbon atoms is 0.1 to 10 parts by mass with respect to 100 parts by mass of the total amount of the alcohol having 3 or more carbon atoms).

The resin composition for forming an optical adjustment layer and the optical adjustment layer may contain known additives such as a plasticizer, a surfactant, and a peeling accelerator, to the extent that does not impede the effect of the present disclosure.

The optical adjustment layer can be formed by, for example, applying the above-described resin composition for forming an optical adjustment layer on a support film and drying the resin composition.

The thickness of the optical adjustment layer is not particularly limited. From the viewpoint of the ease of removing the optical adjustment layer, the thickness of the optical adjustment layer may be 15 µm or less, 12 µm or less, 10 µm or less, 8 µm or less, 7 µm or less, or 6 µm or less. From the viewpoint of the ease of forming the optical adjustment layer and the resolution, the thickness of the optical adjustment layer may be 1 µm or more, 2 µm or more, 3 µm or more, or 4 µm or more.

### <Photosensitive layer>

A photosensitive layer of the present embodiment is a layer formed using a photosensitive resin composition that will be described below. The photosensitive resin composition can be used in accordance with any desired purpose as long as the properties change when the photosensitive resin composition is irradiated with light (for example, being photocured), and the photosensitive resin composition may be of either negative type or positive type. The photosensitive resin composition may contain: (A) a binder polymer, (B) a photopolymerizable compound, and (C) a photopolymerization initiator. Furthermore, the photosensitive resin composition may contain: (D) a photosensitizer, (E) a polymerization inhibitor, (F) an ultraviolet absorber, or other components as necessary. Hereinafter, each component used in the photosensitive resin composition according to the present embodiment will be described in more detail.

### ((A) Binder polymer)

The (A) binder polymer (hereinafter, also referred to as "component (A)") can be produced by, for example, subjecting a polymerizable monomer to radical polymerization. Examples of the above-described polymerizable monomer include styrene, polymerizable styrene derivatives substituted at the α-position or the aromatic ring, such as vinyltoluene, and α-methylstyrene; acrylamides such as diacetone acrylamide; acrylonitrile; ethers of vinyl alcohol such as vinyl-n-butyl ether; (meth)acrylic acid alkyl esters; (meth)acrylic acid benzyl esters such as benzyl methacrylate; (meth)acrylic acid tetrahydrofurfuryl ester, (meth)acrylic acid dimethylaminoethyl ester, (meth)acrylic acid diethylaminoethyl ester, (meth)acrylic acid glycidyl ester, 2,2,2-trifluoroethyl (meth)acrylate, 2,2,3,3-tetrafluoropropyl (meth)acrylate, (meth)acrylic acid, α-bromoacrylic acid, α-chloroacrylic acid, β-furyl (meth)acrylic acid, β-styryl (meth)acrylic acid, maleic acid, maleic anhydride; maleic acid monoesters such as monomethyl maleate, monoethyl maleate, and monoisopropyl maleate; fumaric acid, cinnamic acid, α-cyanocinnamic acid, itaconic acid, crotonic acid, and propiolic acid. These can be used singly or in combination of two or more kinds thereof.

Among these, from the viewpoint of improving plasticity, the polymerizable monomer may include a (meth)acrylic acid alkyl ester. Examples of the (meth)acrylic acid alkyl ester include compounds represented by the following Formula (I), and compounds in which the alkyl groups of these compounds have been substituted with a hydroxyl group, an epoxy group, a halogen group, and the like.

H₂C=C(R⁶)-COOR⁷ (I)

In Formula (I), R⁶ represents a hydrogen atom or a methyl group; and R⁷ represents an alkyl group having 1 to 12 carbon atoms. The alkyl group represented by R⁷ may be linear, branched, or cyclic. Examples of the alkyl group represented by R⁷ include a methyl group, an ethyl group, a propyl group, a butyl group, a pentyl group, a hexyl group, a heptyl group, an octyl group, a nonyl group, a decyl group, an undecyl group, a dodecyl group, and structural isomers of these groups.

Examples of the (meth)acrylic acid alkyl ester represented by Formula (I) include (meth)acrylic acid methyl ester, (meth)acrylic acid ethyl ester, (meth)acrylic acid propyl ester, (meth)acrylic acid butyl ester, (meth)acrylic acid pentyl ester, (meth)acrylic acid hexyl ester, (meth)acrylic acid heptyl ester, (meth)acrylic acid octyl ester, (meth)acrylic acid 2-ethylhexyl ester, (meth)acrylic acid nonyl ester, (meth)acrylic acid decyl ester, (meth)acrylic acid undecyl ester, (meth)acrylic acid dodecyl ester, and a (meth)acrylate compound having an alicyclic structure. Examples of the (meth)acrylate compound having an alicyclic structure include cyclohexyl (meth)acrylate, isobornyl (meth)acrylate, adamantly (meth)acrylate, cyclopentanyl (meth)acrylate, and dicyclopentanyl (meth)acrylate. These can be used singly or in combination of two or more kinds thereof.

From the viewpoint of further improving the resolution, and from the viewpoint of further suppressing the deterioration of resolution caused by post-exposure delay, the component (A) may have a structural unit derived from the (meth)acrylate compound having an alicyclic structure. The content of the structural unit derived from the (meth)acrylate compound having an alicyclic structure may be 1.0% by mass or more, 2.0% by mass or more, 4.0% by mass or more, or 5.0% by mass or more, and may be 15.0% by mass or less, 10.0% by mass or less, 8.0% by mass or less, or 7.0% by mass or less, based on the total mass of the structural units derived from the polymerizable monomers constituting the binder polymer.

From the viewpoint of the alkali developability, the component (A) may contain a carboxy group. The component (A) containing a carboxy group can be produced by, for example, subjecting a polymerizable monomer having a carboxy group and other polymerizable monomers to radical polymerization. The polymerizable monomer having a carboxy group may be (meth)acrylic acid or may be methacrylic acid. The acid value of the component (A) containing a carboxy group may be 50 to 250 mg KOH/g, 50 to 200 mg KOH/g, or 100 to 200 mg KOH/g.

From the viewpoint of improving alkali developability and alkali resistance in a well-balanced manner, the carboxy group content of the component (A) (blending ratio of the polymerizable monomer having a carboxy group with respect to the total amount of the polymerizable monomers used in the binder polymer) may be 12% to 50% by mass, 12% to 40% by mass, 15% to 35% by mass, 15% to 30% by mass, 20% to 30% by mass, or 25% to 30% by mass. When this carboxy group content is 12% by mass or more, the alkali developability tends to improve, and when the carboxy group content is 50% by mass or less, the alkali resistance tends to be excellent.

Since the content of a structural unit derived from a polymerizable monomer having a carboxy group in the component (A) correlates with the blending ratio of the above-described polymerizable monomer having a carboxy group, the content may be 12% to 50% by mass, 12% to 40% by mass, 15% to 35% by mass, 15% to 30% by mass, 20% to 30% by mass, or 25% to 30% by mass.

Regarding the component (A), from the viewpoint of adhesiveness and chemical resistance, styrene or a styrene derivative may be used as a polymerizable monomer. When styrene or a styrene derivative is used as a polymerizable monomer, the content thereof (blending ratio of styrene or the styrene derivative with respect to the total amount of the polymerizable monomers used in the component (A)) may be 10% by mass or more, 30% by mass or more, 50% by mass or more, 55% by mass or more, 60% by mass or more, or 65% by mass or more from the viewpoint of further improving resolution and from the viewpoint of further suppressing the deterioration of resolution caused by post-exposure delay, and the content may be 80% by mass or less, or 70% by mass or less from the viewpoint of shortening the peeling time.

Since the content of the structural unit derived from styrene or a styrene derivative in the component (A) correlates with the blending ratio of the above-described styrene or styrene derivative, the content may be 10% by mass or more, 30% by mass or more, 50% by mass or more, 55% by mass or more, 60% by mass or more, or 65% by mass or more, and may be 80% by mass or less, or 70% by mass or less.

Regarding the component (A), from the viewpoints of resolution and the aspect ratio, (meth)acrylic acid benzyl ester may be used as a polymerizable monomer. From the viewpoints of resolution and the aspect ratio, the content of a structural unit derived from (meth)acrylic acid benzyl ester in the component (A) may be 15% to 50% by mass, 15% to 45% by mass, 15% to 40% by mass, 15% to 35% by mass, 20% to 30% by mass, or 20% to 25% by mass.

The component (A) can be used singly or in combination of two or more kinds thereof. When two or more kinds are used in combination, examples of the component (A) include two or more kinds of binder polymers formed of different polymerizable monomers, two or more kinds of binder polymers having different weight average molecular weights, and two or more kinds of binder polymers having different dispersities.

The component (A) can be produced by a conventional method. Specifically, the component (A) can be produced by, for example, subjecting a (meth)acrylic acid alkyl ester, (meth)acrylic acid, styrene, and the like to radical polymerization.

From the viewpoint of improving mechanical strength and alkali developability in a well-balanced manner, the weight average molecular weight (Mw) of the component (A) may be 8000 or more, 9000 or more, 9500 or more, or 10000 or more, and may be 150000 or less, 100000 or less, 50000 or less, or 40000 or less. When the Mw of the component (A) is 8000 or more, the developing solution resistance tends to be excellent, and when the Mw is 150000 or less, lengthening of the development time tends to be suppressed. The Mw is a value measured by a gel permeation chromatography method (GPC) and calculated using a calibration curve produced using polystyrene standards.

The content of the component (A) may be 30 to 80 parts by mass, 40 to 75 parts by mass, 50 to 70 parts by mass, or 50 to 60 parts by mass, with respect to 100 parts by mass of the total amount of solid content of the component (A) and the component (B) that will be described below. When the content of the component (A) is within this range, the film-coating properties of the photosensitive resin composition and the strength of the photocured parts are further improved.

### ((B) Photopolymerizable compound)

Regarding the (B) photopolymerizable compound (hereinafter, also referred to as "component (B)"), any compound can be used without particular limitation as long as it is a photopolymerizable compound or a photocurable compound; however, for example, a compound having at least one ethylenically unsaturated bond in the molecule can be used.

The component (B) may contain a bisphenol type (meth)acrylate compound. Examples of the bisphenol type (meth)acrylate compound include 2,2-bis(4-((meth)acryloxypolyethoxy)phenyl)propane, 2,2-bis(4-((meth)acryloxypolypropoxy)phenyl)propane, and 2,2-bis(4-((meth)acryloxypolyethoxypolypropoxy)phenyl)propane. These can be used singly or in combination of two or more kinds thereof. As the bisphenol type (meth)acrylate compound, the component (B) may contain 2,2-bis(4-(methacryloxypentaethoxy)phenyl)propane and 2,2-bis(4-(methacryloxydiethoxy)phenyl)propane.

Examples of commercially available compounds as the bisphenol type (meth)acrylate compound include 2,2-bis(4-(methacryloxydiethoxy)phenyl)propane ("BPE-200" manufactured by Shin Nakamura Chemical Co., Ltd.), 2,2-bis(4-(methacryloxypentaethoxy)phenyl)propane ("BPE-500" manufactured by Shin Nakamura Chemical Co., Ltd., or "FA-321M" manufactured by Resonac Corporation), 2,2-bis(4-(methacryloxypentadecaethoxy)phenyl)propane ("BPE-1300" manufactured by Shin Nakamura Chemical Co., Ltd.), and 2,2-bis(4-(methacryloxypolyethoxy)phenyl)propane ("BP-2EM" (EO groups: 2.6 (average value)) manufactured by Kyoeisha Chemical Co., Ltd.).

From the viewpoint of chemical resistance, the content of the bisphenol type (meth)acrylate compound may be 1% to 50% by mass, 3% to 45% by mass, 10% to 45% by mass, 20% to 45% by mass, or 30% to 45% by mass, with respect to the total amount of solid content of the component (A) and the component (B).

From the viewpoint of chemical resistance, the content of the bisphenol type (meth)acrylate compound may be 30% to 99% by mass, 50% to 97% by mass, 60% to 95% by mass, 70% to 95% by mass, or 80% to 95% by mass, with respect to the total amount of solid content of the component (B).

The content of the component (B) may be 20 to 70 parts by mass, 25 to 60 parts by mass, or 30 to 50 parts by mass, with respect to 100 parts by mass of the total amount of solid content of the component (A) and the component (B). When the content of the component (B) is within this range, in addition to the resolution, adhesiveness, and suppressibility of the occurrence of resist tailing of the photosensitive resin composition, the photosensitivity and film-coating properties also tend to be further improved.

### ((C) Photopolymerization initiator)

The (C) photopolymerization initiator (hereinafter, also referred to as "component (C)") is not particularly limited as long as it can polymerize the component (B), and can be appropriately selected from conventionally used photopolymerization initiators.

Examples of the component (C) include aromatic ketones such as
2-benzyl-2-dimethylamino-1-(4-morpholinophenyl)-butanone-1,2-meth yl-1-[4-(methylthio)phenyl]-2-morpholinopropanone-1; quinones such as alkyl anthraquinone; benzoin ether compounds such as benzoin alkyl ether; benzoin compounds such as benzoin and alkylbenzoin; benzyl derivatives such as benzyl dimethyl ketal; 2,4,5-triarylimidazole dimers such as 2-(o-chlorophenyl)-4,5-diphenylimidazole dimer and 2-(o-fluorophenyl)-4,5-diphenylimidazole dimer; and acridine derivatives such as 9-phenylacridine and 1,7-(9,9'-acridinyl)heptane. These can be used singly or in combination of two or more kinds thereof.

Among these, from the viewpoint of improving resolution, the component (C) may contain 2,4,5-triarylimidazole dimer. Examples of the 2,4,5-triarylimidazole dimer include 2-(o-chlorophenyl)-4,5-diphenylimidazole dimer, 2-(o-chlorophenyl)-4,5-bis(m-methoxyphenyl)imidazole dimer, and 2-(p-methoxyphenyl)-4,5-diphenylimidazole dimer. Among these, from the viewpoint of the photosensitivity stability, the component (C) may contain 2-(o-chlorophenyl)-4,5-diphenylimidazole dimer.

Examples of commercially available 2,4,5-triarylimidazole dimer include B-CIM (manufactured by Hodogaya Chemical Co., Ltd., product name).

The content of the component (C) may be 0.01 to 30 parts by mass, 0.1 to 10 parts by mass, 1 to 7 parts by mass, 1 to 6 parts by mass, or 2 to 6 parts by mass, with respect to 100 parts by mass of the total amount of solid content of the component (A) and the component (B). When the content of the component (C) is 0.01 parts by mass or more, photosensitivity, resolution, and adhesiveness tend to improve, and when the content is 30 parts by mass or less, the resist pattern shape tends to be excellent.

### ((D) Photosensitizer)

The photosensitive resin composition according to the present embodiment may contain (D) a photosensitizer (hereinafter, also referred to as "component (D)"). There is a tendency that, by containing the component (D), the absorption wavelength of the actinic rays used for light exposure can be effectively utilized.

Examples of the component (D) include a pyrazoline, a dialkylaminobenzophenone, an anthracene, a coumarin, an acridine, a xanthone, an oxazole, a benzoxazole, a thiazole, a benzothiazole, a triazole, a stilbene, a triazine, a thiophene, a naphthalimide, and a triarylamine. These can be used singly or in combination of two or more kinds thereof. From the standpoint of more effectively utilizing the absorption wavelength of the actinic rays used for light exposure, the component (D) may include a pyrazoline, an anthracene, a coumarin, an acridine, or a dialkylaminobenzophenone, and among these, the component (D) may include a coumarin, an acridine, or a dialkylaminobenzophenone, or the component (D) may include a dialkylaminobenzophenone. Examples of a commercially available dialkylaminobenzophenone include "EAB" manufactured by Hodogaya Chemical Co., Ltd.

When the resin composition contains the component (D), the content thereof may be 1.0 part by mass or less, 0.5 parts by mass or less, 0.15 parts by mass or less, 0.12 parts by mass or less, or 0.10 parts by mass or less, with respect to 100 parts by mass of the total amount of solid content of the component (A) and the component (B). When the content of the component (D) is 1.0 part by mass or less with respect to 100 parts by mass of the total amount of solid content of the component (A) and the component (B), there is a tendency that deterioration of the resist pattern shape and the property of resist skirt generation can be suppressed, and that resolution can be further improved. From the viewpoint that high photosensitivity and favorable resolution are easily obtained, the content of the component (D) may be 0.01 parts by mass or more with respect to 100 parts by mass of the total amount of solid content of the component (A) and the component (B).

### ((E) Photopolymerization inhibitor)

The photosensitive resin composition according to the present embodiment may contain (E) a photopolymerization inhibitor (hereinafter, also referred to as "component (E)". Examples of the component (E) include catechol, resorcinol (resorcin), 1,4-hydroquinone; alkylcatechols such as 2-methylcatechol, 3-methylcatechol, 4-methylcatechol, 2-ethylcatechol, 3-ethylcatechol, 4-ethylcatechol, 2-propylcatechol, 3-propylcatechol, 4-propylcatechol, 2-n-butylcatechol, 3-n-butylcatechol, 4-n-butylcatechol, 2-tert-butylcatechol, 3-tert-butylcatechol, 4-tert-butylcatechol, and 3,5-di-tert-butylcatechol; alkylresorcinols such as 2-methylresorcinol, 4-methylresorciniol, 5-methylresorcinol (orcin), 2-ethylresorcinol, 4-ethylresorcinol, 2-propylresorcinol, 4-propylresorcinol, 2-n-butylresorcinol, 4-n-butylresorcinol, 2-tert-butylresorcinol, and 4-tert-butylresorcinol; alkylhydroquinones such as methylhydroquinone, ethylhydroquinone, propylhydroquinone, tert-butylhydroquinone, and 2,5-di-tert-butylhydroquinone; pyrogallol, and phloroglucin. These can be used singly or in combination of two or more kinds thereof.

### ((F) Ultraviolet absorber)

The photosensitive resin composition according to the present embodiment may contain (F) an ultraviolet absorber (hereinafter, also referred to as "component (F)"). As the photosensitive resin composition of the present embodiment contains the component (F), there is a tendency that a fine resist pattern having excellent resolution can be formed.

The component (F) may be a compound that absorbs light with a wavelength in the range of 340 to 430 nm, or may be a compound that efficiently absorbs light with a wavelength of 365 nm. The molar extinction coefficient of the component (F) for light with a wavelength of 365 nm is in the range of 500 to 50000 L/(mol·cm). The molar extinction coefficient is an index for the ease of absorbing light.

When light exposure of the photosensitive layer is performed using actinic rays with a wavelength of 340 to 430 nm, since the component (F) effectively absorbs light having the exposure wavelength, the component (F) may include at least one kind selected from the group consisting of a benzophenone compound, a benzotriazole compound, and a triazine compound, or may include a benzophenone compound. The benzophenone compound may be a benzophenone compound in which some of the hydrogen atoms have been substituted with groups having an oxygen atom, or may be a benzophenone compound having a hydroxy group.

Examples of the benzophenone compound include
4,4'-dimethoxybenzophenone,
4,4'-bis(trimethylacetoxy)benzophenone,
2,4,4'-trihydroxybenzophenone, 2,2',4,4'-tetrahydroxybenzophenone,
2,3,4,4'-tetrahydroxybenzophenone,
2,2',3,4,4'-pentahydroxybenzophenone, 2,4-dihydroxybenzophenone, 2-hydroxy-4-methoxybenzophenone,
2,2'-dihydroxy-4-methoxybenzophenone,
2-hydroxy-4-(octyloxy)benzophenone, and
2-hydroxy-4-methoxybenzophenone-5-sulfonic acid. Examples of the benzotriazole compound include 2,2-methylenebis[6-(2H-benzotriazo-2-yl)-4-tert-octylphenol],
2-(2'-hydroxy-5'-methacryloxyethylphenyl)-2H-benzotriazole, 2-(2H-benzotriazol-2-yl)-4,6-di-tert-pentylphenol, and
2-(5-chloro-2H-benzotriazol-2-yl)-6-tert-butyl-4-methylphenol. Examples of the triazine compound include
2-[4,6-di(2,4-xylyl)-1,3,5-triazin-2-yl]-5-octyloxyphenol and
2,4,6-tris(2-hydroxy-4-hexyloxy-3-methylphenyl)-1,3,5-triazine.

The content of the component (F) may be 0.05 to 5.0 parts by mass, 0.1 to 4.0 parts by mass, or 0.2 to 2.0 parts by mass, with respect to 100 parts by mass of the total amount of the component (A) and the component (B).

### (Other components)

The photosensitive resin composition according to the present embodiment can optionally contain additives, such as dyes such as Malachite Green, Victoria Pure Blue, Brilliant Green, and Methyl Violet; photochromic agents such as tribromophenylsulfone, Leuco Crystal Violet, diphenylamine, benzylamine, triphenylamine, diethylaniline, and o-chloroaniline; thermal color development inhibitors; plasticizers such as p-toluenesulfonamide; pigments, fillers, antifoaming agents, flame retardants, adhesion promoters, leveling agents, peeling accelerators, antioxidants, fragrances, imaging agents, and thermal cross-linking agents, each in an amount of 0.01 to 20 parts by mass with respect to 100 parts by mass of the total amount of solid content of the component (A) and the component (B). These additives can be used singly or in combination of two or more kinds thereof.

The photosensitive resin composition according to the present embodiment can contain at least one kind of organic solvent as necessary, in order to improve the handleability of the photosensitive composition or to regulate the viscosity and storage stability. As the organic solvent, any conventionally used organic solvent can be used without particular limitation. Specific examples thereof include organic solvents such as methanol, ethanol, acetone, methyl ethyl ketone, methyl cellosolve, ethyl cellosolve, toluene, N,N-dimethylformamide, and propylene glycol monomethyl ether, or mixed solvents thereof. These can be used singly or in combination of two or more kinds thereof.

### <Protective layer>

In the photosensitive element of the present embodiment, a protective layer can also be layered on a surface of the photosensitive layer on the opposite side of the surface in contact with the optical adjustment layer. As the protective layer, for example, a polymer film of polyethylene, polypropylene, or the like may be used. Regarding the protective layer, the same polymer film as the above-described support film may be used, or a different polymer film may be used.

Hereinafter, a method for producing a photosensitive element in which a support film, an optical adjustment layer, a photosensitive layer, and a protective layer are sequentially layered, will be described.

### <Method for producing photosensitive element>

First, for example, a resin composition for forming an optical adjustment layer is applied on a support film and dried to form an optical adjustment layer. Application of the resin composition for forming an optical adjustment layer on the support film can be carried out by, for example, a known method such as roll coating, comma coating, gravure coating, air knife coating, die coating, bar coating, or spray coating.

Drying of the applied resin composition for forming an optical adjustment layer is not particularly limited as long as at least a portion of the solvent such as water can be removed; however, the resin composition may be dried at 70°C to 150°C for 5 to 30 minutes. After drying, the amount of solvent remaining in the optical adjustment layer may be 2% by mass or less, from the viewpoint of preventing diffusion of the solvent in the subsequent steps.

Next, a photosensitive layer may be formed on the optical adjustment layer by applying a photosensitive resin composition on the optical adjustment layer of the support film on which the optical adjustment layer is formed, in the same manner as in the application of the resin composition for forming an optical adjustment layer, and drying the photosensitive resin composition.

Next, a photosensitive element including a support film, an optical adjustment layer, a photosensitive layer, and a protective layer in this order can be produced by laminating a protective layer on the photosensitive layer formed as described above. Furthermore, a photosensitive element including a support film, an optical adjustment layer, a photosensitive layer, and a protective layer in this order may also be obtained by bonding an assembly of the optical adjustment layer formed on the support film, to an assembly of the photosensitive layer formed on the protective layer.

The melt viscosity at 110°C of the photosensitive layer in the photosensitive element can be appropriately selected depending on the type of the base material (undercoat) in contact with the photosensitive layer; however, after drying, the melt viscosity at 110°C may be 50 to 10000 Pa·s, 100 to 5000 Pa·s, or 200 to 1000 Pa·s. When the melt viscosity at 110°C is 50 Pa·s or higher, there is a tendency that wrinkles and voids are not generated during the layering step, and that productivity is improved. When the melt viscosity at 110°C is 10000 Pa·s or less, there is a tendency that the adhesiveness to the undercoat during the layering step is improved, and that the adhesion failure is reduced.

The thickness of the photosensitive layer in the photosensitive element can be appropriately selected depending on the use application; however, the thickness as a thickness after drying may be 1 µm or more, 2 µm or more, 3 µm or more, or 4 µm or more, and may be 14 µm or less, 12 µm or less, 10 µm or less, 9 µm or less, 8 µm or less, or 7 µm or less. When the thickness of the photosensitive layer is 1 µm or more, there is a tendency that industrial coating is easily achieved, and that productivity is improved. When the thickness of the photosensitive layer is 14 µm or less, there is a tendency that the photosensitivity is high, and that since the resist bottom part has excellent photocurability, a resist pattern with excellent resolution and aspect ratio can be formed.

The form of the photosensitive element is not particularly limited. For example, the photosensitive element may be in a sheet form or may have a shape wound in a roll form around a core. When the photosensitive element is wound in a roll form, the photosensitive element may be wound up such that the support film comes on the outer side. Examples of the material for the core include plastics such as a polyethylene resin, a polypropylene resin, a polystyrene resin, a polyvinyl chloride resin, and an AB resin (acrylonitrile-butadiene-styrene copolymer).

On the end faces of the roll-shaped photosensitive element roll obtained in this way, an end face separator may be provided from the viewpoint of protecting the end faces, or a moisture-proof end face separator may be provided from the viewpoint of edge fusion resistance. As a method for packaging, the photosensitive element may be wrapped in a black sheet with low moisture permeability.

The photosensitive element according to the present embodiment can be suitably used in, for example, a method for forming a resist pattern and a method for producing a printed wiring board, which will be described below.

### [Method for forming resist pattern]

A method for forming a resist pattern according to the present embodiment includes: (i) a step of using the above-described photosensitive element to arrange, on a substrate, a photosensitive layer, an optical adjustment layer, and a support film in this order from the substrate side (hereinafter, also referred to as "(i) photosensitive layer and optical adjustment layer forming step"); (ii) a step of removing the support film and exposing the photosensitive layer to actinic rays through the optical adjustment layer (hereinafter, also referred to as "(ii) exposure step"); and (iii) a step of removing uncured parts of the photosensitive layer and the optical adjustment layer from the substrate (hereinafter, also referred to as "(iii) development step"), and may further include other steps as necessary. The resist pattern can be referred to as a photocured product pattern of a photosensitive resin composition or can be referred to as a relief pattern. Depending on the purpose, the resist pattern according to the present embodiment may be used as a resist or may be used for other use applications such as a protective film.

### ((i) Photosensitive layer and optical adjustment layer forming step)

In the photosensitive layer and optical adjustment layer forming step, a photosensitive layer and an optical adjustment layer are formed on a substrate using the above-described photosensitive element.

The substrate is not particularly limited; however, a circuit-forming substrate including an insulating layer and a conductor layer formed on the insulating layer, a die pad (base material for lead frame) such as an alloy base material, or the like is usually used. From the viewpoint of resolution, the surface roughness (Ra) of the substrate may be 10 to 200 nm, 30 to 100 nm, or 40 to 100 nm.

Regarding a method for forming a photosensitive layer and an optical adjustment layer on a substrate, for example, in the case of using a photosensitive element having a protective layer, a photosensitive layer and an optical adjustment layer can be formed on a substrate by removing the protective layer and then pressing the photosensitive layer of the photosensitive element onto the substrate while heating. As a result, a laminated body including a substrate, a photosensitive layer, an optical adjustment layer, and a support film in this order is obtained.

When the photosensitive layer and optical adjustment layer forming step is carried out using the photosensitive element, from the viewpoint of adhesiveness and shape followability, the step may be carried out under reduced pressure. Heating at the time of compression may be carried out at a temperature of 70°C to 130°C, and compression may be carried out at a pressure of 0.1 to 1.0 MPa (1 to 10 kgf/cm²); however, these conditions can be appropriately selected as necessary. When the photosensitive layer of the photosensitive element is heated to 70°C to 130°C, it is not necessary to subject the substrate to a preheating treatment in advance; however, in order to further improve adhesiveness and shape followability, a preheating treatment of the substrate may be carried out.

### ((ii) Exposure step)

In the exposure step, the support film is removed, and the photosensitive layer is exposed to actinic rays through the optical adjustment layer. As a result, exposed parts irradiated with actinic rays may be photocured to form photocured parts (latent image).

Regarding the light exposure method, any known exposure method is applicable, and examples include a method in which actinic rays are irradiated in an image-wise manner through a negative or positive mask pattern called artwork (mask exposure method), an LDI (Laser Direction Imaging) exposure method, and a method in which actinic rays projected from an image of a photomask are used to irradiate in an image-wise manner through a lens (projection exposure method). From the viewpoint of resolution, exposure may be performed using an exposure machine with a numerical aperture (NA) of the lens of 0.16 or more. The NA may be 0.17 or more, 0.20 or more, or 0.22 or more.

The light source of the actinic rays is not particularly limited as long as it is a conventionally used, known light source, and for example, light sources that effectively emit ultraviolet radiation, such as a carbon arc lamp, a mercury vapor arc lamp, an ultra-high pressure mercury lamp, a high pressure mercury lamp, a xenon lamp, a gas laser such as an argon laser, a solid-state laser such as a YAG laser, and a semiconductor laser such as a gallium nitride-based blue-violet laser, are used. Furthermore, light sources that effectively emit visible light, such as a photographic flood lamp and a solar lamp, may also be used. Among these, from the viewpoint of improving resolution and alignment properties in a well-balanced manner, a light source capable of emitting monochromatic i-line light with an exposure wavelength of 365 nm, a light source capable of emitting monochromatic h-line light with an exposure wavelength of 405 nm, or a light source capable of emitting actinic rays with exposure wavelengths of i, h, and g cross-line, may be used, and above all, a light source capable of emitting monochromatic i-line light with an exposure wavelength of 365 nm may be used. Examples of the light source capable of emitting monochromatic i-line light with an exposure wavelength of 365 nm include an ultra-high pressure mercury lamp.

### ((iii) Development step)

In the development step, uncured parts of the photosensitive layer and the optical adjustment layer are removed from the substrate. Through the development step, a resist pattern composed of photocured parts in which the photosensitive layer has been photocured, is formed on the substrate. When the optical adjustment layer is water-soluble, the optical adjustment layer may be removed by washing with water, and then uncured parts other than the photocured parts may be removed using a developing solution; or when the optical adjustment layer is soluble in the developing solution, the optical adjustment layer may be removed using a developing solution, together with the uncured parts other than the photocured parts. Examples of the development method include wet development.

In the case of wet development, development can be carried out by a known wet development method using a developing solution appropriate for the photosensitive resin composition. Examples of the wet development method include a dipping method, a puddle method, a high-pressure spraying method, and methods using brushing, slapping, scrubbing, rocking immersion, and the like, and from the viewpoint of improving resolution, a high-pressure spraying method is most suitable. Development may be carried out using these wet development methods singly or in combination of two or more kinds of methods.

The developing solution is appropriately selected according to the configuration of the photosensitive resin composition. Examples thereof include an alkaline aqueous solution and an organic solvent developing solution.

From the viewpoint of being safe and stable and having favorable workability, an alkaline aqueous solution may be used as the developing solution. Examples of the base of the alkaline aqueous solution include alkali hydroxides such as hydroxide of lithium, sodium, or potassium; alkali carbonates such as carbonate or bicarbonate of lithium, sodium, potassium, or ammonium; alkali metal phosphates such as potassium phosphate and sodium phosphate; alkali metal pyrophosphates such as sodium pyrophosphate and potassium pyrophosphate; sodium borate, sodium metasilicate, tetramethylammonium hydroxide, ethanolamine, ethylenediamine, diethylenetriamine, 2-amino-2-hydroxymethyl-1,3-propanediol, 1,3-diamino-2-propanol, and morpholine are used.

As the alkaline aqueous solution used for development, for example, a dilute solution of 0.1% to 5% by mass sodium carbonate, a dilute solution of 0.1% to 5% by mass potassium carbonate, a dilute solution of 0.1% to 5% by mass sodium hydroxide, or a dilute solution of 0.1% to 5% by mass sodium tetraborate can be used. The pH of the alkaline aqueous solution used for the development may be in the range of 9 to 11, and the temperature of the alkaline aqueous solution can be regulated in accordance with the development of the photosensitive layer. In the alkaline aqueous solution, for example, a surface active agent, an antifoaming agent, and a small amount of an organic solvent for accelerating development may be incorporated. Examples of the organic solvent used for the alkaline aqueous solution include 3-acetone alcohol, acetone, ethyl acetate, an alkoxyethanol having an alkoxy group having 1 to 4 carbon atoms, ethyl alcohol, isopropyl alcohol, butyl alcohol, diethylene glycol monomethyl ether, diethylene glycol monoethyl ether, and diethylene glycol monobutyl ether.

Examples of the organic solvent used for the organic solvent developing solution include 1,1,1-trichloroethane, N-methylpyrrolidone, N,N-dimethylformamide, cyclohexanone, methyl isobutyl ketone, and γ-butyrolactone. From the viewpoint of preventing ignition, these organic solvents may be used as organic solvent developing solutions by adding water in an amount in the range of 1% to 20% by mass.

### (Other steps)

In the method for forming a resist pattern according to the present embodiment, after uncured parts are removed in the development step, a step of further curing the resist pattern by performing heating at 60°C to 250°C or exposure in an exposure amount of 0.2 to 10 J/cm² as necessary, may be included.

### [Method for producing printed wiring board]

A method for producing a printed wiring board according to the present embodiment includes a step of subjecting a substrate on which a resist pattern has been formed by the above-described method for forming a resist pattern, to an etching treatment or a plating treatment to form a conductor pattern, and may include other steps such as a resist pattern removal step as necessary. The method for producing a printed wiring board according to the present embodiment can be suitably used for forming a conductor pattern by using a method for forming a resist pattern using the above-described photosensitive element; however, above all, application to a method for forming a conductor pattern by a plating treatment is more suitable. The conductor pattern can also be called a circuit.

In the etching treatment, a resist pattern formed on a substrate including a conductor layer is used as a mask, the conductor layer of the substrate that is not coated with a resist is removed by etching, and a conductor pattern is formed.

The method for the etching treatment is appropriately selected depending on the conductor layer to be removed. Examples of the etching solution include a cupric chloride solution, a ferric chloride solution, an alkali etching solution, and a hydrogen peroxide-based etching solution, and from the viewpoint of having a favorable etch factor, a ferric chloride solution may be used.

In the plating treatment, a resist pattern formed on a substrate including a conductor layer is used as a mask, and copper, solder, or the like is plated on the conductor layer of the substrate that is not coated with a resist. After the plating treatment, the resist is removed by removal of the resist pattern that will be described below, and the conductor layer coated with this resist is etched to form a conductor pattern.

The method for the plating treatment may be an electroplating treatment or an electroless plating treatment; however, above all, the method may be an electroless plating treatment. Examples of the electroless plating treatment include copper plating such as copper sulfate plating and copper pyrophosphate plating; solder plating such as high-throw solder plating; nickel plating such as Watts bath (nickel sulfate-nickel chloride) plating and nickel sulfamate plating; and gold plating such as hard gold plating and soft gold plating.

After the etching treatment or plating treatment, the resist pattern on the substrate is removed. For the removal of the resist pattern, for example, the resist pattern can be released using an aqueous solution that is more strongly alkaline than the alkaline aqueous solution used in the above-described development step. As this strongly alkaline aqueous solution, for example, a 1% to 10% by mass aqueous solution of sodium hydroxide, or a 1% to 10% by mass aqueous solution of potassium hydroxide is used. Above all, a 1% to 5% by mass aqueous solution of sodium hydroxide or a 1% to 5% by mass aqueous solution of potassium hydroxide may be used.

Examples of the method of removing the resist pattern include an immersion method and a spraying method, and these may be used singly or in combination.

When the resist pattern is removed after the plating treatment is applied, a desired printed wiring board can be produced by further etching the conductor layer coated with a resist through an etching treatment and forming a conductor pattern. The method for the etching treatment at this time is appropriately selected depending on the conductor layer to be removed. For example, the above-mentioned etching solution can be applied.

the method for producing a printed wiring board according to the present embodiment is applicable to the production of single-layer printed wiring boards as well as multilayer printed wiring boards, and is also applicable to the production of printed wiring boards having small-diameter through-holes or the like.

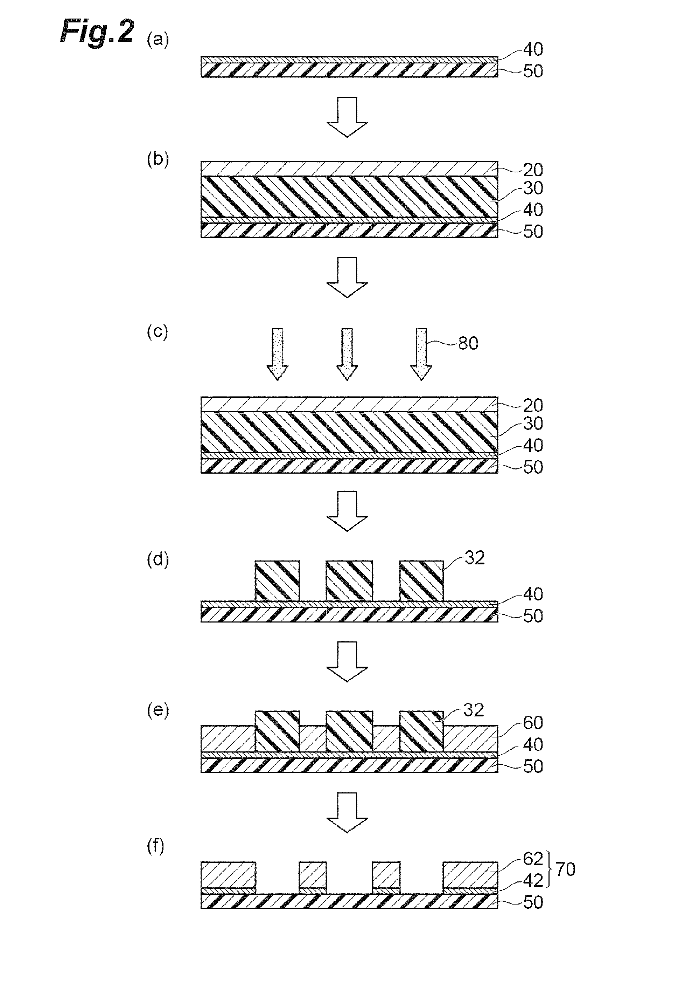

The method for producing a printed wiring board according to the present embodiment can be suitably used for producing high-density package boards, and particularly for producing wiring boards by a semi-additive method. Incidentally, an example of a production step for a wiring board according to a semi-additive method is shown in Fig. 2.

In Fig. 2(a), a substrate on which a conductor layer 40 is formed on an insulating layer 50 (circuit-forming substrate) is prepared. The conductor layer 40 is, for example, a copper layer. In Fig. 2(b), a photosensitive layer 30 and an optical adjustment layer 20 are formed on the conductor layer 40 of the substrate by the above-described photosensitive layer and optical adjustment layer forming step. In Fig. 2(c), the photosensitive layer 30 is irradiated with actinic rays 80 formed by projecting an image of a photomask onto the photosensitive layer 30, through the optical adjustment layer 20 by the above-described exposure step to form photocured parts on the photosensitive layer 30. In Fig. 2(d), regions other than the photocured parts (including the optical adjustment layer) formed by the above-described exposure step are removed from the substrate through a development step, to form a resist pattern 32, which are photocured parts, on the substrate. In Fig. 2(e), a plating layer 60 is formed on the conductor layer 40 of the substrate that is not coated with a resist, by a plating treatment using the resist pattern 32, which is photocured parts, as a mask. In Fig. 2(f), after the resist pattern 32, which is photocured parts, is released using an aqueous solution of a strong alkali, the conductor layer 40 masked with the resist pattern 32 is removed by a flash etching treatment, and a conductor pattern 70 including a plating layer 62 after the etching treatment and a conductor layer 42 after the etching treatment is formed. The materials of the conductor layer 40 and the plating layer 60 may be the same or may be different. When the materials of the conductor layer 40 and the plating layer 60 are the same, the conductor layer 40 and the plating layer 60 may be integrated. In Fig. 2, the projection exposure method is described; however, the resist pattern 32 may be formed by using other exposure methods.

Thus, suitable embodiments of the present disclosure have been described; however, the present disclosure is not limited to the above-described embodiments.

### Examples

Hereinafter, the present disclosure will be described more specifically based on Examples; however, the present disclosure is not intended to be limited to the following Examples. Unless particularly stated otherwise, the "parts" and "%" are on a mass basis.

### (Binder polymer (A-1))

27 parts by mass of methacrylic acid, 50 parts by mass of styrene, 3 parts by mass of 2-hydroxyethyl methacrylate, and 20 parts by mass of benzyl methacrylate were mixed together with 0.9 parts by mass of azobisisobutyronitrile to prepare a solution (a). In 50 parts by mass of a mixed liquid (x) of 30 parts by mass of propylene glycol monomethyl ether and 20 parts by mass of toluene, 0.5 parts by mass of azobisisobutyronitrile was dissolved to prepare a solution (b). 500 g of the mixed liquid (x) was introduced into a flask equipped with a stirrer, a reflux cooler, a thermometer, a dropping funnel, and a nitrogen gas inlet tube, and then the mixed liquid (x) was stirred while blowing nitrogen gas into the flask and heated to 80°C. To the mixed liquid in the flask, the above-described solution (a) was added dropwise over a period of 4 hours at a constant dripping rate, and then the resulting mixture was stirred at 80°C for 2 hours. Next, the above-described solution (b) was added dropwise into the solution in the flask over a period of 10 minutes at a constant dripping rate, and then the solution in the flask was stirred at 80°C for 3 hours. In addition, the solution in the flask was heated to 90°C over a period of 30 minutes and kept warm at 90°C for 2 hours, subsequently stirring was stopped, and the solution was cooled to room temperature (25°C) to obtain a solution of a binder polymer (A-1). The non-volatile content (solid content) of the solution of the binder polymer (A-1) was 49.8% by mass. The Mw of the binder polymer (A-1) was 35000.

The Mw was derived by making measurement by a gel permeation chromatography method (GPC) and calculation using a calibration curve of polystyrene standards. The conditions for GPC were as shown below.

### (Conditions for GPC)

Pump: Hitachi L-6000 type (manufactured by Hitachi, Ltd., product name)
Column: Total of three columns shown below
   Gelpack GL-R420
   Gelpack GL-R430
   Gelpack GL-R440 (all manufactured by Resonac Corporation, product name)
Eluent: Tetrahydrofuran
Measurement temperature: 40°C
Flow rate: 2.05 mL/min
Detector: Hitachi L-3300 type RI (manufactured by Hitachi, Ltd., product name)

### (Binder polymer (A-2))

A solution of a binder polymer (A-2) was obtained in the same manner as for obtaining the solution of the binder polymer (A-1), except that methacrylic acid, styrene, and dicyclopentanyl methacrylate (TCDMA) were used as polymerizable monomers at the mass ratio shown in Table 1. The non-volatile content (solid content) of the solution of the binder polymer (A-2) was 48.0% by mass.

The mass ratio (%) of the polymerizable monomers and the Mw for the binder polymers (A-1) and (A-2) are shown in Table 1.

**[Table 1]**

| | | A-1 | A-2 |
|---|---|---|---|
| | Methacrylic acid | 27 | 27.3 |
| | Styrene | 50 | 66 |
| Monomer (mass ratio) | 2-Hydroxyethyl methacrylate | 3 | - |
| | Benzyl methacrylate | 20 | - |
| | TCDMA | - | 6.7 |
| Mw | | 35000 | 10000 |

### <Preparation of resin composition for forming optical adjustment layer>

A resin composition for forming an optical adjustment layer was obtained by mixing each component shown in the following Table 2 in the blending amount (unit: parts by mass) shown in the same table. Specifically, a water-soluble resin was slowly added to a solvent at room temperature, after the entire amount was added, the mixture was stirred for 1 hour, subsequently a leveling agent was mixed and uniformly dissolved therein, and a resin composition for forming an optical adjustment layer was obtained. The blending amount of the water-soluble resin in Table 2 is a blending amount in terms of solid content.

**[Table 2]**

| Component | Material | Blending amount (parts by mass) |
|---|---|---|
| Water-soluble resin | HC-100G*¹ | 65.0 |
| | K-30*² | 30.0 |
| Leveling agent | WS-314*³ | 0.130 |
| Solvent | Isopropyl alcohol | 250 |
| | Methanol | 10 |
| | Water | 80 |

The details of each component in Table 2 are as follows.
*1: HC-100G (polyvinyl alcohol, manufactured by Taisei Kayaku Co., Ltd., product name: MALTITE HC-100G, solid content (13.5% by mass)
*2: K-30 (polyvinylpyrrolidone, manufactured by Nippon Shokubai Co., Ltd., product name)
*3: WS-314 (acrylic polymer, manufactured by Kyoeisha Chemical Co., Ltd., product name, components: 48% by mass of acrylic polymerization product and 52% by mass of 3-methoxy-3-methyl-1-butanol, composition of the acrylic polymerization product: copolymer of about 6.89 mol% of butyl (meth)acrylate, about 61.4 mol% of isobutyl (meth)acrylate, and about 31.7 mol% of terminal methoxy group EO-modified (meth)acrylate)

### <Preparation of photosensitive resin composition>

A photosensitive resin composition was obtained by mixing each component shown in the following Table 3 in the blending amount (unit: parts by mass) shown in the same table. The blending amount of the binder polymer in Table 3 is a blending amount in terms of solid content.

**[Table 3]**

| | | | Example 1 | Example 2 | Comparative Example 1 | Comparative Example 2 |
|---|---|---|---|---|---|---|
| Photosensi tive resin composition | Component (A) | A-1*⁴ | 57.0 | - | 57.0 | - |
| | | A-2*⁵ | - | 57.0 | - | 57.0 |
| | Component (B) | FA-321M*⁶ | 34.5 | 34.5 | 34.5 | 34.5 |
| | | FA-024M*⁷ | 2.5 | 2.5 | 2.5 | 2.5 |
| | | BP-2EM*⁸ | 6.0 | 6.0 | 6.0 | 6.0 |
| | Component (C) | B-CIM*⁹ | 5.5 | 5.5 | 5.5 | 5.5 |
| | Component (D) | PZ-501D*¹⁰ | 0.027 | 0.027 | 0.027 | 0.027 |
| | Component (E) | Q-TBC-5P*¹¹ | 0.040 | 0.040 | 0.040 | 0.040 |
| | | LA-7RD*¹² | 0.010 | 0.010 | 0.010 | 0.010 |
| | Component (F) | SEESORB-10 6*¹³ | 0.279 | 0.279 | 0.279 | 0.279 |
| | Other components | LCV*¹⁴ | 0.770 | 0.770 | 0.770 | 0.770 |
| | | SF-808H*¹⁵ | 1.0 | 1.0 | 1.0 | 1.0 |
| | | MKG*¹⁶ | 0.050 | 0.050 | 0.050 | 0.050 |
| | Solvent | Acetone | 45 | 45 | 45 | 45 |
| | | Toluene | 16 | 16 | 16 | 16 |
| | | Methanol | 6 | 6 | 6 | 6 |
| Optical adjustment layer (absorbance: 0.018; refractive index: 1.549) | | | Present | Present | Absent | Absent |
| Support film (absorbance: 0.064; refractive index: 1.916) | | | FS-31 | FS-31 | FS-31 | FS-31 |
| Definition (µm) | Without post-exposure delay | | 1.4 | 1.0 | 1.8 | 1.9 |
| | Delay of 6 hours after exposure | | 1.5 | 1.2 | 2.5 | 3.0 |

The details of each component in Table 3 are as follows.
*4: Binder polymer (A-1) synthesized as described above
*5: Binder polymer (A-2) synthesized as described above
*6: FA-321M (manufactured by Resonac Corporation, product name)
   2,2-Bis(4-(methacryloxypolyethoxy)phenyl)propane (adduct of 10 mol in average of ethylene oxide)
*7: FA-024M (manufactured by Resonac Corporation, product name)
   (PO)(EO)(PO)-modified dimethacrylate (adduct of 6 mol in average of ethylene oxide and 12 mol in average of propylene oxide (total value))
*8: BP-2EM (manufactured by Kyoeisha Chemical Co., Ltd., product name)
   2,2-bis(4-(methacryloxypolyethoxy)phenyl)propane (EO group: 2.6 (total value))
*9: B-CIM (manufactured by Hodogaya Chemical Co., Ltd., product name)
   2,2'-bis(2-chlorophenyl)-4,4',5,5'-tetraphenylbiimidazole
*10: PZ-501D (manufactured by Nippon Chemical Works Co., Ltd., product name)
   1-phenyl-3-(4-methoxystyryl)-5-(4-methoxyphenyl)-pyrazoline
*11: Q-TBC-5P (manufactured by DIC Corporation, product name)
   4-tert-butylcatechol
*12: LA-7RD (manufactured by ADEKA Corporation, product name)
   4-hydroxy-2,2,6,6-tetramethylpiperidine-N-oxyl
*13: SEESORB-106 (benzophenone-based ultraviolet absorber, manufactured by Shipro Kasei Kaisha, Ltd., product name)
*14: LCV (Leuco Crystal Violet, Yamada Chemical Co., Ltd., color developing agent)
*15: SF-808H (manufactured by Sanwa Kasei Corporation, product name, adhesion promoter)
   mixture of carboxybenzotriazole, 5-amino-1H-tetrazole, and methoxypropanol
*16: MKG (Malachite Green, manufactured by Osaka Organic Chemical Industry, Ltd., dye)

### <Production of photosensitive element>

### (Production of photosensitive element of Example)

A polyethylene terephthalate film (manufactured by Toray Industries, Inc., product name "FS-31") having a thickness of 16 µm was prepared as a support film. A resin composition for forming an optical adjustment layer was applied on the support film such that a uniform thickness was obtained, and the resin composition was dried for 5 minutes in a hot air convection type dryer at 110°C to form an optical adjustment layer having a thickness after drying of 5 µm. Next, a photosensitive resin composition was applied on the optical adjustment layer such that a uniform thickness was obtained, and the photosensitive resin composition was dried for 10 minutes in a hot air convection type dryer at 100°C to form a photosensitive layer having a thickness after drying of 6 µm. Next, a polyethylene protective film (manufactured by Tamapoly Co., Ltd., product name "NF-15A", protective layer) was bonded to the photosensitive layer, and a photosensitive element in which a support film, an optical adjustment layer, a photosensitive layer, and a protective layer were layered in this order was obtained.

### (Production of photosensitive element of Comparative Example)

A photosensitive element in which a support film, a photosensitive layer, and a protective layer were layered in this order was obtained in the same manner as in the Example, except that an optical adjustment layer was not provided.

### <Absorbance>

### (Absorbance of optical adjustment layer)

The photosensitive element of Example 1 was laminated (layered) on the surface of a slide glass (manufactured by Matsunami Glass Ind., Ltd., white slide glass cut No. 1 S1126). Lamination was carried out by bringing the photosensitive layer of the photosensitive element into contact with the surface of the slide glass while peeling the protective layer, using a heat roll at 110°C at a compression pressure of 0.4 MPa and a roll speed of 1.0 m/min. After the photosensitive layer was layered on the slide glass, the support film was peeled, and a laminated body 1 composed of a slide glass, a photosensitive layer, and an optical adjustment layer was obtained. For the laminated body 1, the absorbance was measured using a U-3310 type spectrophotometer (manufactured by Hitachi High-Tech Science Corporation), under the measurement conditions of a wavelength range of 330 to 700 nm, a scan speed of 300 nm/min, a scan interval of 0.50 nm. From the obtained absorption spectrum, the absorbance at an exposure wavelength of 365 nm was recorded as absorbance A. Thereafter, the optical adjustment layer was peeled from the laminated body 1, and then the absorbance measured again under the same conditions was recorded as absorbance B. A value obtained by subtracting the absorbance B from the absorbance A was defined as the absorbance of the optical adjustment layer.

### (Absorbance of support film)

The operation was carried out in the same manner as for the measurement of the absorbance of the optical adjustment layer, except that a laminated body 2 composed of a slide glass, a photosensitive layer, and a support film, which was obtained using the photosensitive element of Comparative Example 1 without peeling the support film, was used instead of the laminated body 1. The absorbance measured for the laminated body 2 was recorded as absorbance C, the absorbance measured again under the same conditions after peeling the support film from the laminated body 2 was recorded as absorbance D, and a value obtained by subtracting the absorbance D from the absorbance C was defined as the absorbance of the support film.

### <Refractive index>

The refractive indices of the optical adjustment layer and the support film in the photosensitive element for light with a wavelength of 365 nm were each measured using a spectroscopic ellipsometer (UVISEL2, manufactured by Horiba, Ltd.) under the following measurement conditions.
(Measurement conditions for refractive index)
Incident angle: 60 degrees
Measurement wavelength range: 190 nm to 826 nm
Spot diameter: ellipse having a size of 1 mm × 1.5 mm (sample surface)

### <Definition>

A substrate having a copper layer (Ra: 40 nm) was washed with acid, washed with water, and then dried under an air flow. Thereafter, the substrate was heated to 80°C, and a photosensitive element was laminated (layered) on the copper surface of the substrate to obtain a laminated body. Lamination was carried out by bringing the photosensitive layer of the photosensitive element into contact with the copper surface of the substrate while peeling the protective layer, using a heat roll at 110°C at a compression pressure of 0.4 MPa and a roll speed of 1.0 m/min.

In the case of a laminated body without an optical adjustment layer, a chrome-on-glass photomask (resolution negative: one having a wiring pattern with a line width/space width of x/x (x: 1 to 10, unit: µm) was used as a negative for evaluating resolution on a support film, and the photosensitive layer was exposed to light in a predetermined amount of energy using an exposure apparatus FPA-3000iW (NA = 0.24, manufactured by Canon, Inc.) (exposure treatment). After the exposure, the support was peeled, the photosensitive layer was exposed, a 1% by mass aqueous solution of sodium carbonate at 27°C was sprayed thereon for a time period three times the shortest developing time (shortest time required for unexposed parts to be removed), and unexposed parts were removed (development treatment). In the case of a laminated body with an optical adjustment layer, light exposure and development were carried out in the same manner as described above, except that the support film was peeled, and light exposure was carried out through the optical adjustment layer.

After the development treatment, in a resist pattern in which space parts (unexposed parts) had been neatly removed, and line parts (exposed parts) were formed without causing any residue, twisting, meandering, and chipping, the smallest value of space width (unit: µm) was defined as the definition. A smaller numerical value of the definition means more favorable resolution.

The definition was obtained in the same manner as described above, except that after the exposure, the laminated bodies were stored at 23°C in a light-shielded state for 6 hours, and then a development treatment was carried out, and the resolution in the case of a delay of 6 hours after exposure was evaluated. The laminated body without an optical adjustment layer was stored with the support film attached after exposure.

### Reference Signs List

1: photosensitive element, 2: support film, 3, 20: optical adjustment layer, 4, 30: photosensitive layer, 5: protective layer, 32: resist pattern, 40: conductor layer, 42: conductor layer after etching treatment, 50: insulating layer, 60: plating layer, 62: plating layer after etching treatment, 70: conductor pattern, 80: actinic rays.

## Claims

1. A photosensitive element comprising: a support film, an optical adjustment layer, and a photosensitive layer in this order,
wherein the optical adjustment layer has an absorbance of 0.060 or less for light with a wavelength of 365 nm, and the optical adjustment layer has a refractive index of 1.800 or less for light with a wavelength of 365 nm.

2. The photosensitive element according to claim 1, wherein the optical adjustment layer contains a water-soluble resin.

3. The photosensitive element according to claim 1, wherein the optical adjustment layer has a thickness of 1 to 15 µm.

4. The photosensitive element according to claim 1, wherein the photosensitive layer has a thickness of 1 to 14 µm.

5. A method for forming a resist pattern, the method comprising:
a step of using the photosensitive element according to any one of claims 1 to 4 to arrange, on a substrate, a photosensitive layer, an optical adjustment layer, and a support film in this order from the substrate side;
a step of removing the support film and exposing the photosensitive layer to actinic rays through the optical adjustment layer; and
a step of removing an uncured part of the photosensitive layer and the optical adjustment layer from the substrate.

6. The method for forming a resist pattern according to claim 5, wherein light exposure is performed using an exposure machine having a lens numerical aperture of 0.16 or greater.

7. A method for producing a printed wiring board, the method comprising:
a step of subjecting a substrate on which a resist pattern has been formed by the method for forming a resist pattern according to claim 5, to an etching treatment or a plating treatment to form a conductor pattern.

8. The method for producing a printed wiring board, the method comprising:
a step of subjecting a substrate on which a resist pattern has been formed by the method for forming a resist pattern according to claim 6, to an etching treatment or a plating treatment to form a conductor pattern.
